# FASCICULE DE BREVET EUROPEEN

(11) **EP 0 981 657 B1**
(45) Date de publication et mention de la délivrance du brevet: **25.07.2001**
(21) Numéro de dépôt: 98925724.1
(22) Date de dépôt: 15.05.1998
(51) Int. Cl.: C30B 11/00

(54) **DISPOSITIF DE SOLIDIFICATION ET DE CONTROLE EN CONTINU DE LA CROISSANCE CRISTALLINE**
VORRICHTUNG ZUR ERSTARRUNG UND ZUR KONTINUIERLICHEN ÜBERWACHUNG DER KRISTALLZÜCHTUNG
DEVICE FOR SOLIDIFICATION AND CONTINUOUS CONTROL OF CRYSTAL GROWTH

(30) Priorité: 16.05.1997 FR 9706046
(43) Date de publication de la demande: 01.03.2000
(73) Titulaire: COMMISSARIAT A L'ENERGIE ATOMIQUE, 75015 Paris Cédex 15 (FR); CENTRE NATIONAL D'ETUDES SPATIALES, 75015 Paris (FR)
(72) Inventeur: KERNEVEZ, Nelly, F-38700 Corenc (FR); WALES, Bernard, F-38320 Eybens (FR); BORGIS, André, F-38000 Grenoble (FR); ROLLAND, Emmanuel, F-38560 Jarrie (FR)
(74) Mandataire: Signore, Robert
(86) Numéro de dépôt international: FR9800976
(87) Numéro de publication internationale: WO9853122

(56) Documents cités:
- EP-A- 0 549 449
- DD-A- 222 046
- FR-A- 2 597 884

## Description

La présente invention a pour objet un dispositif de solidification et de contrôle en continu de la croissance cristalline d'un matériau dopé ou d'un alliage, conducteurs de l'électricité, à partir d'un liquide ou bain fondu, permettant le contrôle en continu de la croissance cristalline de ce matériau dopé ou de cet alliage, en particulier le contrôle en continu de la teneur en dopant du matériau dopé ou de la teneur en élément allié de l'alliage.

L'invention s'applique en particulier à tout matériau dont les propriétés dépendent de la structure fine et dont il est intéressant de contrôler l'évolution de la structure durant le processus d'élaboration.

L'invention s'applique en cristallogénèse à toute croissance d'un monocristal inorganique dopé semi-conducteur ou conducteur.

Le dopant peut être une impureté introduite dans le cristal par exemple du phosphore ou du bore dans un cristal de silicium, du gallium dans un cristal de germanium, du fer dans un cristal de GaAs, etc. ou un élément de substitution, par exemple de l'indium dans un cristal de Ga₁₋ₓInₓSb avec O<x≤1, du mercure dans un cristal de Cd_{1-y}Hg_{y}Te avec 0<y≤1. Par ailleurs, le dopant peut représenter par exemple de 0,01% à moins de 50% en poids du cristal.

L'invention s'applique aussi en métallurgie, à l'élaboration d'alliages dont les propriétés d'usage mécaniques, thermiques, électriques dépendent de la structure fine liée par exemple à la répartition de composition, il s'agit par exemple d'alliages mis en oeuvre dans le domaine de la microélectronique, de l'optique intégrée, de lasers à cristal etc.

L'invention s'applique en particulier aux alliages métalliques à base d'étain comme étain bismuth (0 à 3%) ou eutectique SnBi ou eutectique SnCu.

L'invention s'applique à des études de solidification sur des matériaux conducteurs ou semi-conducteurs afin d'améliorer la connaissance des liens entre les propriétés et la structure, les études sont menées au sol ou dans l'espace dans des conditions de microgravité par exemple pour contrôler les processus de solidification sur des matériaux modèles.

La croissance cristalline à partir d'un bain fondu est la méthode la plus utilisée pour élaborer des cristaux métalliques ou semi-conducteurs de bonne qualité.

Les propriétés les plus recherchées sont la qualité structurale ou cristalline et l'homogénéité de composition. Les méthodes de croissance cristalline les plus répandues sont les méthodes de tirage de Czochralski, de fusion de zone, de zone flottante ou encore les méthodes de Bridgman ou de Stockbarger horizontales ou verticales.

Actuellement, les seuls procédés qui permettent de contrôler en continu la composition d'un matériau opaque tel qu'un semi-conducteur métallique pendant son élaboration sans perturber sa croissance, sont basés sur l'effet Seebeck qui considère l'interface liquide/solide comme une jonction de thermocouple.

Un procédé et un dispositif basés sur l'effet Seebeck sont décrits dans les documents FR-A-2 597 884 et US-A-4 797 174. Ce procédé dénommé "Seebeck double gradient" consiste à mesurer la différence de température entre d'une part la température d'une interface mobile solide/liquide et d'autre part la température d'une interface fixe solide/liquide d'un même alliage à une composition déterminée. Le diagramme de phase de l'alliage permet de déduire la variation de composition à partir de l'écart de température entre les interfaces à l'équilibre et hors équilibre.

Le procédé décrit dans les deux documents mentionnés plus haut autorise donc une mesure en continu de la qualité-chimique du cristal formé.

Ainsi, il est possible d'agir rétroactivement sur les causes de défaut dans le cristal et d'obtenir ainsi un solide de qualités améliorées.

Cependant, ce type de mesure exige un dispositif lourd et complexe qui en limite les applications tant au sol; que dans l'espace. Le dispositif comporte en effet deux fours juxtaposés, deux systèmes de refroidissement, ainsi qu'un asservissement complexe de régulation, ce qui rend le dispositif encombrant, la puissance électrique consommée importante et accroît par voie de conséquence le prix de revient du dispositif.

Un autre procédé qui fait également appel à l'effet Seebeck et qui est dénommé "Seebeck monogradient", est décrit dans les documents FR-A-2 685 483 et US-A-5 394 828. Il permet d'aboutir à un dispositif plus simple de solidification d'un matériau conducteur de l'électricité dopé et de contrôle en continu de sa valeur en dopant.

Le dispositif décrit dans ces documents remédie aux inconvénients du dispositif du document FR-A-2 597 884 décrit plus haut. Il consiste à mesurer la différence de température entre deux interfaces mobiles, l'une sur l'alliage, ou le matériau dopé, l'autre sur le corps pur non allié ou le matériau de référence non dopé. Un seul four est nécessaire et la régulation est simplifiée.

La figure 1 illustre un dispositif tel qu'il est décrit dans le document FR-A-2 685 483.

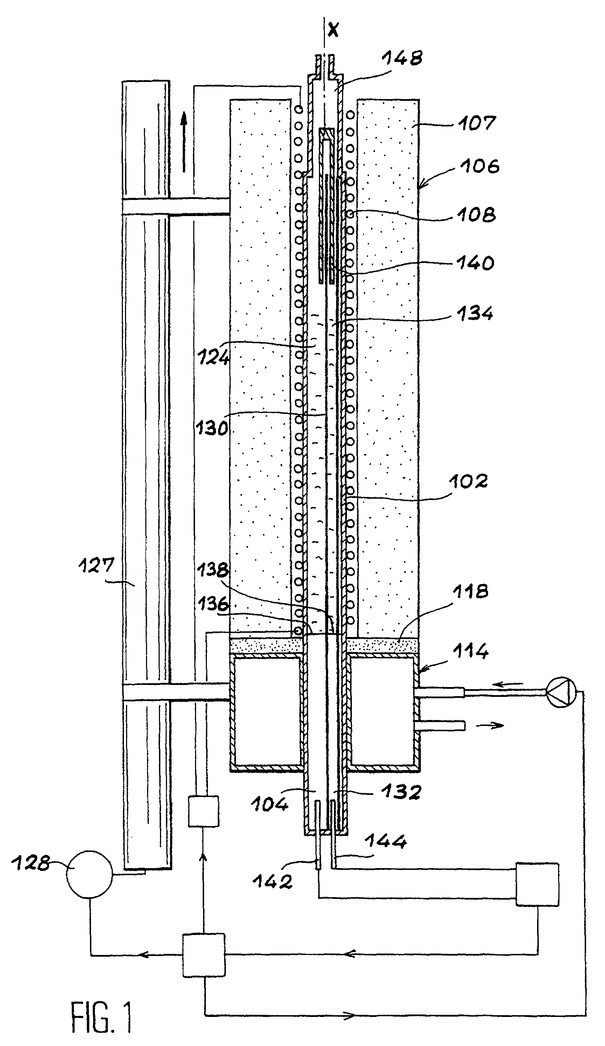

Le dispositif représenté sur la figure 1 comporte un creuset 102 de forme cylindrique, destiné à contenir le cristal 104 dopé à élaborer. X représente l'axe longitudinal du creuset 102.

Ce dispositif comporte de plus un four 106 à symétrie axiale, équipé de résistances chauffantes 108.

Un manchon 107 isolant électrique et thermique est prévu pour entourer les éléments chauffants 108.

Ce dispositif comporte en outre un système de refroidissement 114 du type à circulation d'eau, placé en dessous du four 106 et dans son prolongement.

Afin de bien séparer les zones de refroidissement de celles de chauffage, une couronne 118 isolante thermiquement est prévue entre le four 106 et le système de refroidissement 114.

L'ensemble four 106, couronne 118 isolante et système de refroidissement 114 de l'invention permet la réalisation d'un gradient de températures longitudinal, selon l'axe X de symétrie du creuset 102.

A cet effet, l'ensemble système de refroidissement 114-couronne isolante 118 et four 106 est solidaire d'un support 127 équipé de rails de guidage et d'un moteur 128 permettant une translation selon l'axe X de l'ensemble 114-118-106, le creuset 102 restant fixe.

Un second creuset 130 de forme cylindrique est logé à l'intérieur du creuset 102 et présente un diamètre inférieur à celui du creuset 102.

Ce creuset 130 se présente sous la forme d'un tube orienté selon l'axe X de symétrie du creuset 102. Il est solidaire du creuset 102.

Ce creuset interne 130 est rempli d'un composé identique à celui à élaborer, mais exempt de dopant.

L'ensemble four-couronne isolante-système de refroidissement permet d'une part l'obtention du solide dopé 104, en équilibre thermodynamique avec son liquide dopé 124 ainsi que l'obtention d'un solide pur 132 en équilibre thermodynamique avec son liquide non dopé 134.

Les références 136 et 138 indiquent respectivement l'interface solide dopé/liquide dopé et solide non dopé/liquide non dopé.

La solidification est effectuée en déplaçant l'ensemble four-couronne-système de refroidissement par rapport aux creusets 102 et 130, ainsi, les deux interfaces 136 et 138 solide/liquide progressent simultanément jusqu'à la solidification complète des composés purs et dopés.

D'autre part, le solide dopé 104 et le solide non dopé 132 sont équipés d'un contact électrique respectivement 142, 144.

Enfin, pendant toute la durée de la solidification, les deux liquides 124 dopé et 134 non dopé sont court-circuités électriquement par un pont ou fil conducteur 140 ayant la forme d'une épingle à cheveux dont chaque branche plonge dans un liquide.

Le pont 140 doit être réalisé dans un matériau bon conducteur électrique, insoluble dans les liquides, et capable d'être mis en forme.

Il est effectivement possible de trouver un matériau répondant à ces critères, ainsi dans le document FR-A-2 685 483 on utilise du tungstène ou du carbone, mais son pouvoir thermoélectrique génère, dans la configuration du dispositif de l'art antérieur tel qu'il est décrit sur la figuré 1, des effets parasites masquant les phénomènes à mesurer.

En effet, le contact entre le matériau liquide et l'électrode se comporte comme une jonction de thermocouple générant un effet thermoélectrique parasite aux bornes de mesures. Cet effet peut théoriquement être annulé si les deux contacts sont parfaitement symétriques.

Or l'expérience montre que la symétrie thermique requise est impossible à réaliser dans cette configuration. En effet la forme d'épingle place l'électrode dans le gradient thermique longitudinal du four. L'électrode est soumise à des effets thermoélectriques parasites sur sa longueur, en particulier dans la zone trempant dans le liquide et des courants peuvent circuler d'une zone à l'autre de l'électrode. Le liquide est le siège de convections thermiques non corrélées d'un bain à l'autre et les électrodes ne sont pas nécessairement positionnées de façon identique dans les bains notamment en longueur et en centrage. Même si l'on isole l'électrode des bains, sauf en leur extrémité, et qu'on les centre, la symétrie entre les deux bains ne peut être maintenu lors du déplacement du four.

Ainsi des essais sur une électrode de tungstène dans des bains d'étain liquide ont montré des variations de l'ordre du degré sur la différence de température des extrémités lors du déplacement du four, et de quelques dixièmes dans les minutes suivant l'arrêt du four.

Ces variations entraînent des effets thermoélectriques supérieurs au signal à mesurer. Une symétrie meilleure que le centième de degré serait nécessaire vu le pouvoir thermoélectrique du couple tungstène/étain (20 µV/K) et la faiblesse des signaux à mesurer (voisins du µV). Cette symétrie est impossible à réaliser dans la configuration d'électrode en épingle à cheveux de l'art antérieur.

Enfin cette configuration d'une électrode en épingle rend complexe la gestion des volumes libres coté liquide. En effet, en orientation horizontale ou en microgravité il est nécessaire de fermer les creusets coté liquide pour maintenir leur étanchéité l'un vis-à-vis de l'autre, et si possible, d'implanter des compensateurs de volumes pour s'assurer que l'électrode sera toujours en contact avec les liquides.

La présence de l'épingle nécessite donc un passage étanche délicat à réaliser dans les compensateurs.

L'invention a pour but de fournir un dispositif de solidification d'un matériau conducteur de l'électricité qui remédie aux inconvénients des dispositifs de l'art antérieur cités ci-dessus et qui surmonte les problèmes rencontrés dans les dispositifs de l'art antérieur, en particulier le dispositif décrit sur la figure 1.

L'invention a encore pour but en particulier de fournir un dispositif permettant de réaliser des mesures fiables, reproductibles dans lequel le contact ou court-circuit électrique entre les liquides ne génère pas d'effets thermoélectriques parasites.

Ce but et d'autres encore sont atteints conformément à l'invention par un dispositif de solidification d'un matériau dopé par un dopant ou d'un alliage, conducteurs de l'électricité, et de contrôle en continu de la croissance cristalline comportant :
- Des premiers moyens pour former un premier liquide du matériau non dopé ou du corps pur non allié en équilibre thermodynamique avec un premier solide dudit matériau non dopé ou dudit corps pur, lesdits premiers moyens comprenant une première cavité de forme essentiellement allongée pour recevoir ledit matériau non dopé ou ledit corps pur;
- des seconds moyens pour former un second liquide dudit matériau dopé ou dudit alliage en équilibre thermodynamique avec un second solide dudit matériau dopé ou dudit alliage, les dits seconds moyens comprenant une seconde cavité de forme essentiellement allongée pour recevoir ledit matériau dopé ou ledit alliage;
- des moyens pour mesurer une différence de potentiel électrique entre le premier solide et le second solide, cette différence de potentiel étant représentative de la teneur en dopant ou de la teneur en élément allié à l'interface second liquide-second solide, c'est-à-dire à l'interface liquide dopé-solide dopé ou alliage liquide-alliage solide;
- des moyens pour mettre en court-circuit électrique ledit premier liquide et ledit second liquide ;
le dispositif selon l'invention étant caractérisé en ce que lesdits moyens pour mettre en court circuit électrique ledit premier liquide et ledit second liquide consistent en un passage de dimension réduite, isotherme et conducteur, reliant lesdites première et seconde cavité.

Le dispositif selon l'invention dans lequel lesdits moyens de mise en court-circuit sont constitués par un tel passage ne présente pas les inconvénients des dispositifs de l'art antérieur et en particulier du dispositif décrit sur la figure 1.

Ce dispositif permet entre autres d'assurer un excellent contact électrique entre d'une part le premier liquide se trouvant dans la première cavité et d'autre part le second liquíde se trouvant dans la seconde cavité. Une telle configuration des moyens de mise en court circuit sous forme de passage permet de rendre symétrique l'électrode aussi bien thermiquement que géométriquement.

Il en résulte que les effets thermoélectriques engendrés par les contacts électriques entre les zones liquides des matériaux sont réduits, voire éliminés et que l'on peut ainsi réaliser une mesure physique stable.

En outre, la dimension des moyens de mise en court-circuit sous forme de passage se trouve limitée par rapport notamment aux moyens en épingle à cheveux, ce qui se répercute également de manière positive sur la taille et l'encombrement globaux du dispositif de solidification.

Le passage réalise également une étanchéité parfaite entre les deux liquides, étanchéité qu'il était impossible d'atteindre avec un court-circuit électrique ou "électrode" en forme d'épingle à cheveux qui équipe le dispositif de l'art antérieur décrit dans la figure 1.

De ce fait, le passage permet que le dispositif selon l'invention puisse être utilisé de manière sûre aussi en position horizontale, ou en microgravité.

Cette étanchéité est assurée tout en laissant libre l'extrémité des cavités ("côté chaud") du côté où se trouvent les matériaux liquides, cette extrémité peut de préférence recevoir des moyens d'obturation ou de fermeture tels qu'une simple fermeture et/ou des moyens de compensation de volume, sans qu'il soit nécessaire -comme dans l'art antérieur-d'installer un connecteur étanche difficile à réaliser pour l'électrode, c'est-à-dire pour les moyens de mise en court circuit.

De même, des moyens d'obsturation et/ou de compensation de volume peuvent être prévus à l'extrémité des cavités du côté -côté froid- où se trouvent les matériaux solides.

Le dispositif selon l'invention présente une grande souplesse d'utilisation ainsi qu'une grande fiabilité qu'il n'était pas possible d'assurer avec les dispositifs de l'art antérieur.

Le passage est situé de préférence au voisinage de l'extrémité des deux cavités c'est-à-dire que lorsque le dispositif selon l'invention est vertical, le passage est situé de préférence plutôt dans la partie dite "haute" des deux cavités.

Avantageusement, les deux cavités sont identiques et ont de préférence une forme cylindrique pour favoriser la symétrie aussi bien thermique que géométrique.

De préférence, les deux cavités sont réalisées dans un seul et même creuset ce qui favorise encore la symétrie, et la compacité du dispositif.

Le passage est généralement réalisé dans le même matériau que les cavités, par exemple dans le même matériau que le creuset unique dont est muni préférentiellement le dispositif.

Par passage de dimension réduite, on entend généralement un passage dont les dimensions sont faibles par rapport aussi bien à la longueur qu'au diamètre de chacune des cavités c'est-à-dire que par exemple la longueur du passage représente au plus 5% de la longueur des cavités. Le passage peut par exemple prendre la forme d'un tube ou canal de préférence de faible section circulaire c'est-à-dire d'un diamètre de 1 à 4 mm, et de faible longueur, c'est-à-dire de 3 à 5 mm.

Un tel passage peut par exemple être pratiqué dans la paroi définissant les deux cavités lorsque celles-ci sont définies à l'intérieur d'un creuset unique.

Par passage isotherme : on entend que le passage comporte des moyens pour maintenir la température constante le long du passage.

Par passage conducteur, on entend que le passage comporte des. moyens conducteurs de l'électricité à savoir un élément conducteur ou une pièce conductrice permettant de réaliser un court-circuit électrique entre les liquides.

Cet élément conducteur peut se présenter sous toute forme adéquate, comme cela est décrit par exemple dans les modes de réalisation du passage décrits plus loin, c'est-à-dire qu'il peut revêtir par exemple la forme d'un fil, d'une paroi ou pastille en un matériau conducteur ; de même cet élément ou cette pièce peut être constitué en tout matériau conducteur de l'électricité adéquate, c'est-à-dire répondant aux contraintes de compatibilité chimique avec l'alliage liquide, et de faible coefficient thermo-électrique avec cet alliage et de dilatation volumique compatible avec le matériau du creuset. Parmi ces matériaux on peut citer le tungstène, le carbone, etc.

De manière particulièrement avantageuse, le passage est placé perpendiculairement à l'axe principal longitudinal du dispositif, et des deux cavités ce qui a pour effet de limiter voire d'annuler, l'influence du gradient longitudinal du dispositif de solidification, cette influence était particulièrement néfaste dans le cas du dispositif de l'art antérieur comportant une "épingle à cheveux".

Selon un premier mode de réalisation du dispositif selon l'invention, le passage qui a la forme par exemple d'un tube ou d'un canal de préférence de section circulaire, comporte une paroi ou pastille en un matériau conducteur de l'électricité dont l'axe est de préférence perpendiculaire à l'axe du dispositif.

Selon un second mode de réalisation du dispositif selon l'invention, le passage comporte et est obstrué par un matériau isolant électriquement analogue par exemple à celui des cavités.

Le dit matériau isolant est traversé par un élément tel qu'un fil en matériau conducteur de l'électricité.

Selon un troisième mode de réalisation du dispositif selon l'invention un corps ou bouchon poreux en matériau électriquement isolant est placé dans le passage, et les pores, orifices, ou capillaires de ce corps ou bouchon poreux ont été par exemple remplis au préalable par exemple par aspiration du matériau liquide non dopé ou du corps pur non allié afin d'assurer le contact électrique.

Selon un mode pratique de mise en oeuvre les premiers moyens mentionnés plus haut comprennent outre ladite première cavité des premiers moyens de chauffage pour chauffer une première partie de ladite première cavité et y former ledit premier liquide dudit matériau non dopé ou dudit corps pur non allié, et des premiers moyens de refroidissement pour refroidir une seconde partie de ladite première cavité et y former ledit premier solide dudit matériau non dopé ou dudit corps pur non allié, et les seconds moyens mentionnés plus haut comprennent outre la seconde cavité, des seconds moyens de chauffage pour chauffer une première partie de ladite seconde cavité et y former ledit second liquide dudit matériau dopé ou dudit alliage, et des seconds moyens de refroidissement pour refroidir une seconde partie de ladite seconde cavité et y former ledit second solide dudit matériau dopé ou dudit alliage.

De préférence, lesdits premier et second moyens de chauffage consistent en un seul et même four à symétrie axiale, généralement de forme globalement tubulaire entourant par exemple le creuset unique dans lequel sont définies les deux cavités.

De même, lesdits premier et second moyens de refroidissement peuvent consister en un seul et même système, de nouveau généralement de forme globalement tubulaire, entourant par exemple le creuset unique dans lequel sont définies les deux cavités. Les cavités étant de préférence identiques. Une telle disposition de l'ensemble thermique constitué essentiellement par le four, le système de refroidissement, le dispositif de fourniture d'énergie au four et au système de refroidissement, est particulièrement avantageuse car l'électronique de commande et de régulation est par exemple deux fois moins importante que celle du dispositif décrit dans le document FR-A-2 597 884. Par ailleurs, l'énergie thermique et la puissance maximale nécessaires sont de même deux fois plus faibles que dans ce document.

Du fait, que en outre, en particulier grâce à la compacité du passage dont est pourvu le dispositif selon l'invention l'encombrement de ce dispositif est encore réduit par rapport au dispositif du document FR-A-2 685 483, le dispositif selon l'invention est parfaitement bien adapté à une application spatiale où l'énergie, la puissance maximale, le poids et l'encombrement sont limités.

De façon avantageuse, les points de mesure de la différence de potentiel dans le solide dopé et le solide non dopé sont très proches, c'est-à-dire que la distance entre les points de mesure est comprise par exemple entre 5 et 12 mm, ce qui facilite leur maintien à une même température.

Le matériau solide obtenu par le dispositif de l'invention est généralement un monocristal.

On précise d'autre part que par matériau conducteur de l'électricité, il faut comprendre aussi bien un matériau conducteur de l'électricité qu'un matériau semi-conducteur.

Par dopant, on entend aussi bien des impuretés qu'un élément de substitution d'un élément du matériau par un autre.

Par dopé, ou allié, il faut généralement comprendre une concentration en dopant ou en élément allié inférieur à 50 % en poids de l'alliage ou du matériau dopé, par exemple de 0,01 % à 49,99 % en poids.

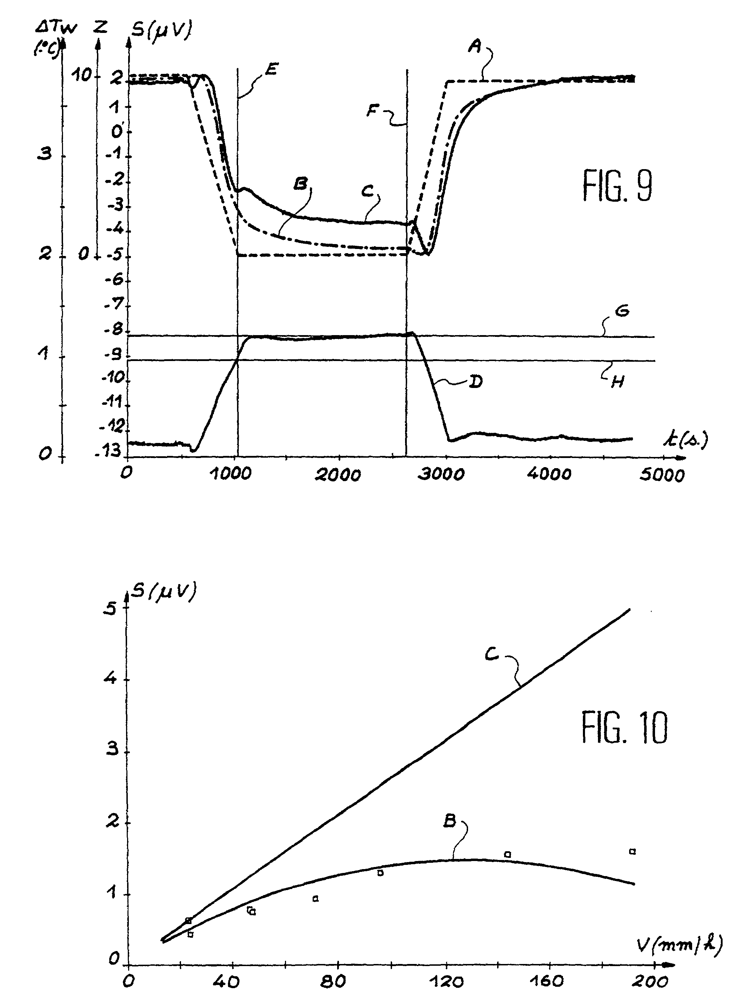

D'autres caractéristiques et avantages de l'invention ressortiront mieux de la description qui va suivre, donnée à titre illustratif et non limitatif en référence aux dessins annexés dans lesquels :
- la figure 1 déjà décrite plus haut est une vue schématique en coupe longitudinale c'est-à-dire de préférence verticale d'un dispositif de l'art antérieur.
- la figure 2 est une vue schématique en coupe longitudinale c'est-à-dire de préférence verticale du dispositif selon l'invention, dans le cas par exemple d'une solidification verticale de type BRIDGMAN ou STOCKBARGER.
- la figure 3A est une vue schématique en coupe transversale c'est-à-dire de préférence horizontale d'un premier mode de réalisation du passage faisant partie du dispositif selon l'invention.
- la figure 3B est une vue schématique en coupe selon la ligne AA de la figure 3A.
- la figure 4A est une vue schématique en coupe transversale, c'est-à-dire de préférence horizontale d'un deuxième mode de réalisation du passage faisant partie du dispositif selon l'invention.
- la figure 4B est une vue schématique en coupe selon la ligne BB de la figure 4A.
- la figure 5A est une vue schématique en coupe transversale, c'est-à-dire de préférence horizontale d'un troisième mode de réalisation du passage faisant partie du dispositif selon l'invention.
- la figure 5B est une vue schématique en coupe selon la ligne CC de la figure 5A.
- la figure 6 est une vue schématique en coupe transversale d'un exemple de réalisation du passage faisant partie du dispositif selon l'invention.
- la figure 7A est une vue en coupe transversale, c'est-à-dire de préférence horizontale, d'un exemple du deuxième mode de réalisation du passage faisant partie du dispositif selon l'invention.
- la figure 7B est une vue en perspective éclatée du porte-électrode du passage selon la figure 7A.
- la figure 8A est une vue schématique en coupe longitudinale d'un exemple de compensation des volumes libres du côté "chaud" du dispositif selon l'invention.
- la figure 8B est une vue schématique en coupe longitudinale d'un exemple de compensation des volumes libres du côté "froid" du dispositif selon l'invention.
- la figure 9 est un graphique illustrant les mesures de surfusion effectués avec le dispositif de l'invention analogue à celui de la figure 2, le four étant horizontal, le passage étant réalisé conformément à la configuration décrite sur la figure 6, et la vitesse de déplacement du four étant de 72 mm/h.
   Sur ce graphique, la courbe A représente l'évolution de la position du four Z exprimée en mm en fonction du temps exprimé en secondes, la courbe B représente l'évolution de l'écart de température ΔT_{w} exprimé en °C mesuré au niveau du passage en fonction du temps exprimé en secondes, la courbe C représente l'évolution du signal thermoélectrique Seebeck S exprimé en µV en fonction du temps exprimé en secondes, et enfin la courbe D représente l'évolution du signal Seebeck "corrigé" exprimé en µV, en fonction du temps exprimé en secondes
- la figure 10 est un graphique qui reporte les mesures expérimentales de surfusion exprimées en µV (représentées par des carrés) obtenues à partir de graphiques tels que celui de la figure 9 pour différentes vitesses de déplacement du four exprimées en mm/h et les compare aux mesures obtenues par mise en oeuvre d'un dispositif classique de l'art antérieur (courbe B) à double gradient, et aux résultats obtenus par application d'un modèle théorique valable uniquement aux faibles vitesses (courbe C).

La figure 1 représente un dispositif de l'art antérieur et a déjà été détaillée plus haut dans la description, lors de l'étude de l'art antérieur sur lequel est basé la présente invention.

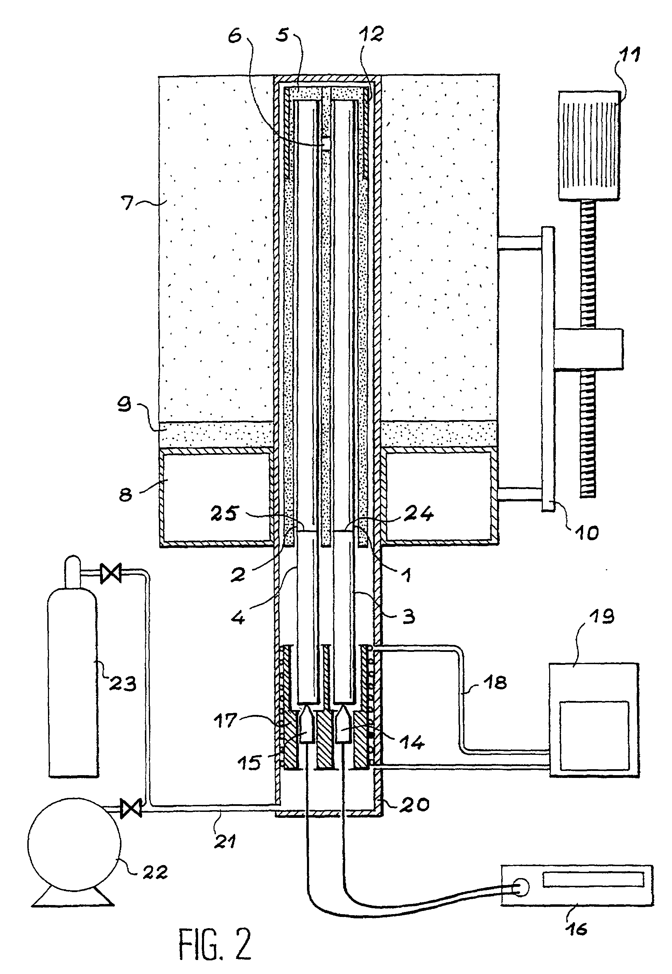

Sur la figure 2, on a représenté le dispositif selon l'invention, certaines parties du dispositif n'ont pas été représentées, mais du fait que la structure du dispositif selon l'invention est pour une grande partie analogue à celle du dispositif de la figure 1, on pourra pour plus de détails éventuellement se reporter à la figure 1 ou au document FR-A-2 685 483.

En fait, le dispositif selon l'invention peut être défini comme un dispositif "Seebeck Monogradient" tel que celui du document FR-A-2 685 485 dans lequel les moyens de mise en court circuit des deux liquides ont été modifiées.

Le principe de la mesure effectuée avec le dispositif selon l'invention est le même que celui de tout dispositif de type "Seebeck Monogradient" et il est déjà décrit dans le document FR-A-2 685 485, ce principe ne sera donc pas détaillé plus avant ici.

Comme tout dispositif classique BRIDGMAN ou STOCKBARGER faisant appel au procédé "SEEBECK Monogradient" le dispositif de la figure 2 comporte deux cavités 1 et 2 contenant respectivement d'une part le matériau dopé ou l'alliage 3 et d'autre part le matériau de référence 4 c'est-à-dire le matériau non-dopé ou le corps pur.

Selon l'invention, ces cavités sont avantageusement identiques et sont réalisées dans un seul et même creuset. Les cavités 1, 2 de même que le creuset 5, sont de forme essentiellement allongée et sont de préférence de forme cylindrique, les diamètres des cylindres étant inférieurs à leurs hauteurs.

Le matériau constituant le creuset 5 et définissant aussi les cavités 1,2 est généralement un matériau présentant une très bonne compatibilité chimique avec l'alliage liquide, et un faible coefficient de dilatation en fonction de la température et isolant électrique, il est choisi par exemple parmi le quartz ou le nitrure de bore.

Le creuset 5 est placé dans un dispositif créant un gradient thermique tel qu'un four 7 à symétrie axiale muni de résistances chauffantes (non représentées) susceptibles de fournir par exemple une puissance de chauffe de 500 W. L'alimentation du four en courant peut être contrôlée par un circuit de traitement tel qu'un micro-ordinateur (non représenté). Le dispositif selon l'invention comporte également un système de refroidissement 8 par exemple du type à circulation d'eau, placé en dessous du four 7 et dans son prolongement.

Le système de circulation d'eau peut être équipée d'une électrovanne commandée aussi par le dispositif de traitement (non représentés).

Afin de bien séparer les zones de refroidissement de celles de chauffage, un élément isolant telle qu'une couronne 9 isolante thermiquement est prévue entre le four et le système de refroidissement.

L'ensemble du four 7, de l'élément isolant telle qu'une couronne isolante thermiquement 9, et du système de refroidissement 8 permet de réaliser un gradient de températures longitudinal.

Dans ce but, l'ensemble du four, couronne isolante et système de refroidissement est solidaire d'un support telle qu'une table à déplacement 10 équipée d'un rail de guidage et actionnée par un moteur 11 qui permet une translation de l'ensemble four 7, couronne isolante 9, système de refroidissement 8 selon l'axe longitudinal du dispositif de solidification, le creuset 5 et les deux cavités 1 et 2 restant fixes. Le fonctionnement du moteur 11 peut également être piloté par le dispositif de traitement tel qu'un micro-ordinateur.

L'ensemble four-couronne isolante-système de refroidissement permet d'une part l'obtention d'un solide dopé ou de l'alliage en équilibre thermodynamique avec le liquide dopé ou de l'alliage liquide ainsi que l'obtention d'un solide pur en équilibre thermodynamique avec le liquide non-dopé ou le corps pur, non allié, liquide. Les références 24 et 25 indiquent respectivement l'interface solide dopé ou alliage/liquide dopé ou alliage liquide et solide non dopé/liquide non dopé ou corps pur, non allié, liquide.

Dans le cas de très faibles concentrations en dopant ou en élément allié, ces deux interfaces 24 et 25 sont à des niveaux très voisins, des cotes très voisines, du fait que les températures de fusion du composé pur non allié ou du composé non dopé et du composé dopé ou de l'alliage sont peu différentes.

La solidification est effectuée de manière classique en déplaçant l'ensemble four-couronne-système de refroidissement 7,8,9 par rapport au creuset 5, et aux cavités 1,2.

Ainsi, les deux interfaces solide/liquide progressent simultanément jusqu'à la solidification complète des composés purs ou non dopé et du composé dopé ou de l'alliage.

D'autre part le dispositif selon l'invention comprend comme mentionné plus haut, des moyens pour mesurer une différence de potentiel électrique entre le premier solide et le second. Ces moyens comprennent tout d'abord par exemple des contacts électriques 14 et 15, se présentant chacun par exemple sous la forme d'une pointe, par exemple en cuivre pur et dénommée "pointe de mesure Seebeck". Chacun des contacts électriques équipe respectivement le solide dopé ou l'alliage, et le solide non dopé ou le corps pur.

Les contacts électriques, par exemple les pointes en cuivre pur 14,15 sont reliés à un système de mesure tel qu'un nanovoltmètre 16 permettant de mesurer la différence de potentiel apparaissant entre les contacts électriques 14,15.

Le signal électrique fourni par le système de mesure peut être envoyé vers le dispositif de traitement tel qu'un micro-ordinateur (non représenté), qui selon la différence de potentiel mesurée peut éventuellement modifier la vitesse de déplacement de l'ensemble four-couronne-système de refroidissement par l'intermédiaire du moteur et/ou la tension d'alimentation des éléments chauffants du four, par l'intermédiaire de la source d'alimentation électrique et à la fermeture de l'électrovanne, pour modifier le profil de températures du système.

Afin d'éviter les effets thermoélectriques parasites au contact par exemple cuivre/solide, les contacts électriques tels que les pointes en cuivre sont placés de préférence dans la zone la plus froide de ces solides, c'est-à-dire à leur extrémités "inférieure" dans le cas d'un dispositif vertical, de plus les contacts électrique tels que les pointes 14, 15 et les extrémités des solides sont en outre placées de préférence dans des moyens de régulation de la température et d'homogénéisation thermique.

Selon la figure 2, ces moyens sont constitués par une masse de cuivre 17 dans laquelle sont prévues des conduites où circule un fluide 18 tel que de l'eau, dont le débit et la température sont régulés par des moyens adéquats tels qu'un cryostat 19.

Le creuset 5 est placé dans une enceinte 20, qui peut être sous vide ou bien sous atmosphère contrôlée. Ainsi, sur la figure 2, l'enceinte est elle reliée dans sa partie basse (il est bien entendu que cette connexion peut également être réalisée dans sa partie haute) à un circuit 21 connecté à un système de pompage 22 ou à une bouteille de gaz 23 par exemple d'argon.

Conformément à la caractéristique essentielle de l'invention le dispositif de solidification comprend des moyens pour mettre en court circuit électrique les liquides contenus dans chacune des cavités 1 et 2.

Ces moyens sont, selon l'invention constitués par un passage 6 de dimension réduite, isotherme et conducteur reliant lesdites cavités 1 et 2.

Sur la figure 2, ce passage se présente sous la forme d'un orifice 6 traversant, ici de section sensiblement circulaire, pratiqué dans la paroi de séparation définissant les deux cavités 1, 2 dans l'unique creuset 5.

Ce passage est de dimension réduite ce qui signifie par exemple que son diamètre est faible par rapport au diamètre de chacune des cavités et au diamètre du creuset, ainsi chacune des cavités a par exemple un diamètre de 3 à 6 mm tandis que le creuset a un diamètre de 15 à 28 mm et que le passage a un diamètre de 1 à 4 mm et une longueur de 3 à 5mm correspondant ici à l'épaisseur de la paroi entre les deux cavités.

Le passage se situe de préférence vers l'extrémité des cavités, du côté "chaud" de celles-ci, c'est-à-dire que dans le cas d'un dispositif vertical le passage se situe dans la partie "haute" des cavités, et du dispositif à savoir de préférence dans la partie haute du four, et il est aussi maintenu en température par ce four.

La zone des cavités, et du creuset, où se trouve le passage 6 peut être rendue encore plus homogène en température à l'aide d'une masse très conductrice de la chaleur par exemple en cuivre ou en argent ou d'un caloduc 12 réalisé par exemple avec du sodium comme fluide caloporteur.

De préférence, comme illustré sur la figure 2, le passage 6 est placé perpendiculairement à l'axe de déplacement ou axe longitudinal du dispositif ce qui permet de limiter l'influence du gradient longitudinal du dispositif de solidification.

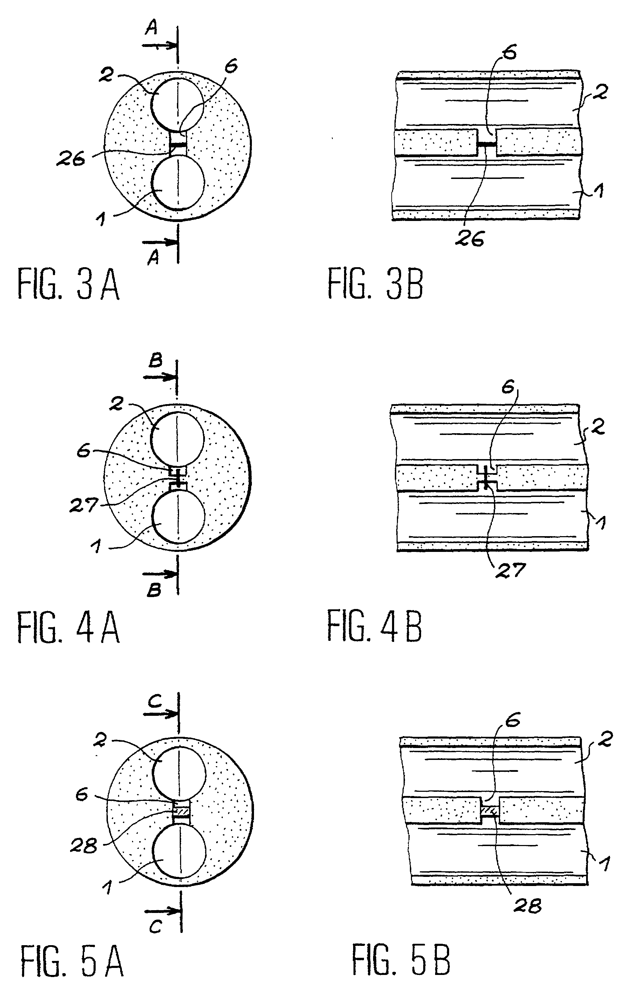

Sur les figures 3A et 3B, on a illustré un premier mode de réalisation du passage 6.

Celui-ci se présente sous la forme d'un tube ou canal de section sensiblement circulaire dont l'axe est perpendiculaire à l'axe des deux cavités 1, 2 pratiquées dans le creuset 5 par exemple en nitrure de bore. Dans ce mode de réalisation, une petite pastille 26 par exemple en tungstène ou en molybdène est fixée dans ledit tube ou canal 6.

Cette pastille 26 est d'épaisseur et de diamètre faibles, c'est-à-dire par exemple d'une épaisseur de 0,2 mm et d'un diamètre de 4 mm afin de minimiser la dissymétrie thermique. Elle assure le contact électrique et l'étanchéité entre les deux échantillons. L'axe de la pastille est perpendiculaire à l'axe du dispositif et donc au gradient thermique principal.

Sur les figures 4A et 4B, on a illustré un deuxième mode de réalisation du passage faisant partie du dispositif selon l'invention.

De même que sur les figures 3A et 3B, le passage est sous la forme d'un tube ou d'un canal 6 de section sensiblement circulaire dont l'axe est perpendiculaire à l'axe des deux cavités 1, 2 pratiquées dans le creuset 5 par exemple en nitrure de bore et qui est réalisé dans le creuset entre ces deux cavités 1, 2.

Dans ce mode de réalisation, un fil court 27 par exemple en tungstène ou en molybdène est fixé dans le tube ou canal par exemple à l'aide d'un porte électrode généralement en nitrure de bore.

Sur les figures SA et 5B, on a illustré un troisième mode de réalisation du passage. Le passage est analogue à celui des figures 3A, 3B, 4A et 43 et est réalisé dans un creuset 5 par exemple en nitrure de bore et il comporte selon ce mode de réalisation un bouchon poreux 28.

Ce bouchon 28 peut être réalisé à partir d'un matériau isolant électriquement tel que de l'alumine poreuse dans laquelle on a percé de fins capillaires. Le bouchon peut être préalablement rempli du matériau de référence par aspiration. Dans ce cas, il ne s'agit plus de limiter les gradients thermiques mais la diffusion du matériau dopé ou de l'alliage vers le matériau de référence non dopé ou le corps pur en maintenant un contact électrique.

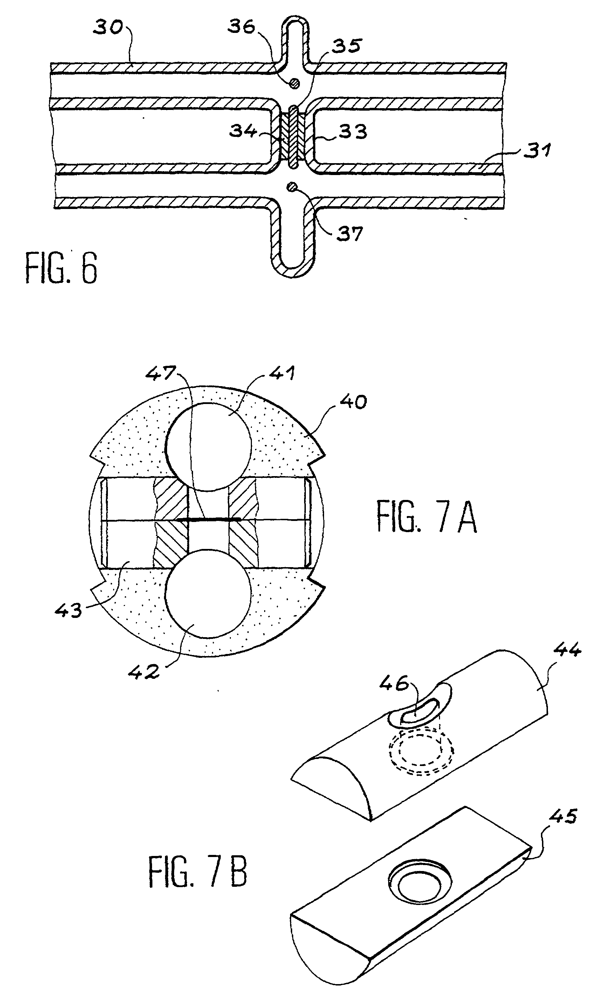

Sur la figure 6, on a illustré un exemple de réalisation du passage faisant partie du dispositif selon l'invention. Cet exemple correspond au deuxième mode de réalisation du passage tel qu'il a déjà été décrit sur les figures 4A et 4B.

Chaque échantillon est contenu dans un creuset 30, 31, par exemple en quartz. Dans un pont en quartz 33 définissant le passage caractéristique de l'invention est soudée une "perle de quartz" 34 dans laquelle est enfilé un fil par exemple de tungstène 35 de petit diamètre.

Deux thermocouples 36, 37 placés de chaque coté du pont 33 permettent de mesurer les gradients thermiques et de réaliser une compensation des effets thermoélectriques engendrés.

Sur les figures 7A et 7B, on a illustré un autre exemple du deuxième mode de réalisation du passage faisant partie du dispositif selon l'invention.

Un creuset par exemple en nitrure de bore (40) comporte deux cavités cylindriques (41) et (42) pour le logement des échantillons. Un évidement cylindrique est réalisé perpendiculairement à ces cavités pour placer le porte-électrode (43).

Ce porte-électrode est selon la figure 7B constitué de deux demi cylindres d'un rayon égal par exemple à 3,5 mm par exemple en nitrure de bore (44) et (45) comportant un évidement cylindrique (46) et d'un diamètre par exemple de 3 mm qui va définir le passage selon l'invention.

L'électrode (47) par exemple en tungstène est assemblée et pincée entre ces deux demi cylindres. L'échantillon, en fondant vient combler les espaces vides et réaliser le contact électrique avec l'électrode. Le creuset peut comporter des évidements pour le logement de thermocouples. Ces thermocouples permettent de contrôler l'homogénéité thermique et éventuellement de compenser par calcul les effets thermoélectriques engendrés par des dissymétries thermiques.

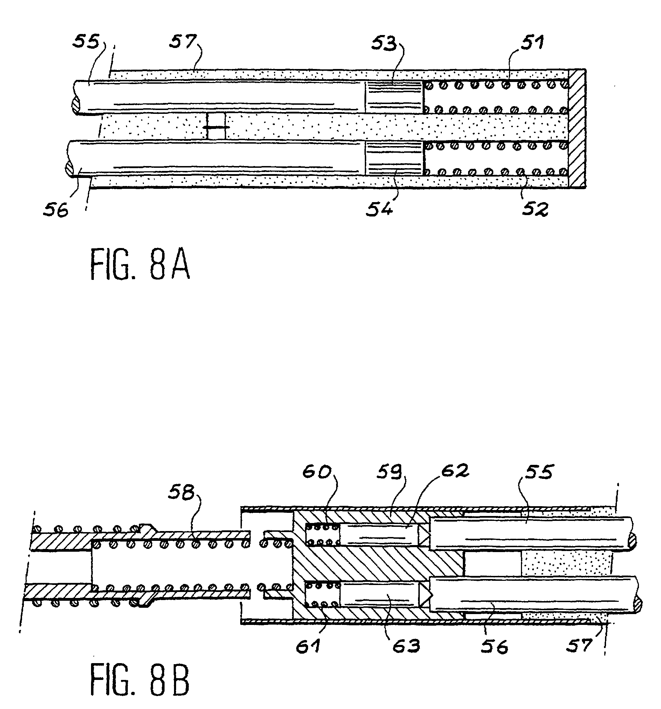

Sur les figures 8A et 8B, on a illustré un exemple de compensation des volumes libres résultant de la fusion et de la dilatation thermique.

Du fait que comme on l'a déjà indiqué plus haut, le passage selon l'invention est de préférence intégré dans le creuset unique dans lequel sont pratiquées les deux cavités, la mise en oeuvre du creuset et des systèmes de gestion des volumes libres s'en trouve grandement facilité en particulier du coté chaud de l'appareil, par rapport au dispositif de l'art antérieur comportant une "épingle à cheveux".

Ainsi sur la figure 8A, on a illustré un exemple de compensation des volumes libres du "côté chaud" de l'appareil où la température peut atteindre par exemple de 600 à 1000°C.

Deux ressorts 51 et 52 par exemple en graphite poussent deux pistons 53 et 54, qui gèrent l'expansion des échantillons liquides 55, 56 dans le creuset par exemple en nitrure de bore 57 et veillent à ce que les échantillons liquides ne comportent pas de bulles préjudiciables à la solidification. Ces pistons 53, 54 peuvent être étanches au liquide mais poreux aux gaz pour faciliter l'évacuation des gaz occlus.

Sur la figure 8B, on a illustré un exemple de compensation des volumes libres du "côté froid" de l'appareil où la température est généralement la température ambiante, par exemple 20 °C.

Un ressort principal 58 gère l'expansion ou la rétraction moyenne en poussant sur une pièce 59 contenant l'extrémité solide des échantillons. Deux petits ressorts 60 et 61 placés à l'intérieur de la pièce 59, gèrent les dilatations différentielles des échantillons en poussant sur les pointes de mesure Seebeck 62 et 63. C'est-à-dire que les ressorts 60, 61 s'appuient par une de leurs extrémités sur la surface interne de la pièce 59 et poussent par l'autre de leurs extrémités les pointes de mesure.

Les exemples suivants donnés à titre illustratif et non limitatifs illustrent les résultats obtenus par la mise en oeuvre du dispositif selon l'invention.

### EXEMPLES

On a réalisé une série d'essais pour illustrer le fonctionnement du dispositif "Seebeck monogradient" selon l'invention et pour en valider le concept.

Les essais ont été effectués avec un dispositif analogue à celui de la figure 2, le four étant horizontal, et le passage étant réalisé conformément à la configuration décrite sur la figure 6.

Les conditions expérimentales sont les suivantes :
- Corps pur : étain pur à 10⁻⁵
- Alliage : Etain-Bismuth à 0,5% atomique de
   Bi.
- Température du four : 600°C
- Température de la zone froide : 20°C
- Gradient longitudinal à l'interface : environ 150°C/cm.

Divers cycles de solidification fusion et diverses mesures de la surfusion ont été réalisées à différentes vitesses au moyen du déplacement du four.

La figure 9 joint présente un exemple de la mesure de surfusion réalisée devant un cycle de solidification-fusion pour une vitesse de déplacement du four de 72 mm/h.

Sur ce graphique la courbe A représente l'évolution de la position du four Z (mm) en fonction du temps (s). La première partie de cette courbe (jusqu'à la droite E correspondant à la fin de la solidification) décrit la solidification, tandis que la partie de cette courbe située après la droite F décrit la fusion.

La courbe B représente l'évolution de l'écart de température mesuré au niveau du passage ΔT_{w} (°C) (dérive thermique) en fonction du temps (s).

La courbe C représente l'évolution du signal thermoélectrique Seebeck S (µV) en fonction du temps (s) aux bornes des échantillons. Ce signal est un signal Seebeck perturbé par la dérive thermique.

On constate sur la courbe C que le signal Seebeck évolue lors du déplacement du four du fait de la contribution de la structure solide et de la contribution de la dérive le l'écart de tempérarure (courbe B).

A l'arrêt de la solidification (après la droite E) un transitoire "rapide" est observé sur le signal Seebeck, il est du au "retour à l'équilibre" de la température de l'interface de l'alliage après la "perturbation" que constitue le déplacement de l'interface par le four. L'amplitude de ce transitoire est appelée surfusion et évolue en fonction de la vitesse de solidification.

Afin de mesurer ce transitoire plus facilement il importe d'éliminer la dérive thermique, on soustrait donc numériquement la contribution de l'écart de température du signal Seebeck mesuré perturbé (courbe C) et l'on obtient aussi la courbe D qui correspond au signal Seebeck corrigé égal au signal Seebeck mesuré diminué de l'écart mesuré (Δt_{w}) multiplié par le pouvoir thermoélectrique électrode étain.

Le signal Seebeck corrigé (courbe D), débarrassé de la dérive lente négative observée sur la courbe C permet une mesure de la surfusion qui est représentée par l'écart entre les droites G et H de la figure 9.

On effectue de la même manière, en utilisant des graphiques analogues à celui de la figure 9, des mesures de surfusion pour diverses vitesses de déplacement.

On a reporté sur le graphique de la figure 10 les mesures expérimentales de surfusion ainsi obtenues avec le dispositif de l'invention (en µV) en fonction des diverses vitesses de déplacement (mm/h), ces mesures expérimentales sont figurées par des carrés.

Pour valider le concept du dispositif Seebeck monogradient selon l'invention, on a également porté sur la figure 10 les résultats des mesures de surfusion obtenus pas mise en oeuvre d'un dispositif classique Seebeck double gradient connu sous le nom de "Mephisto" tel que celui qui est décrit dans le brevet FR-A-2 597 884 (courbe B).

De même, on a porté sur le graphique de la figure 10 une courbe obtenue par application d'un modèle théorique valable uniquement aux faibles vitesses (courbe C).

On remarque que les résultats expérimentaux obtenus avec le dispositif classique (courbe B) et avec le dispositif selon l'invention (carrés) présentent un très bon accord.

De même, les résultats expérimentaux obtenus avec le dispositif selon l'invention sont en accord avec le modèle théorique (courbe C) qui est valable uniquement aux faibles vitesses.

Le dispositif selon l'invention a ainsi été validé car on obtient sensiblement les mêmes résultats que dans l'art antérieur mais sans en avoir les inconvénients et en bénéficiant au contraire des améliorations, effets et avantages décrits plus haut.

## Revendications

1. Dispositif de solidification d'un matériau dopé par un dopant ou d'un alliage, conducteurs de l'électricité, et de contrôle en continu de la croissance cristalline de ce matériau ou de cet alliage, comportant :
- Des premiers moyens pour former un premier liquide du matériau non dopé ou du corps pur non allié en équilibre thermodynamique avec un premier solide dudit matériau non dopé ou dudit corps pur non allié, lesdits premiers moyens comprenant une première cavité de forme essentiellement allongée pour recevoir ledit matériau non dopé ou ledit corps pur;
- des seconds moyens pour former un second liquide dudit matériau dopé ou dudit alliage en équilibre thermodynamique avec un second solide dudit matériau dopé ou dudit alliage, lesdits seconds moyens comprenant une seconde cavité de forme essentiellement allongée pour recevoir ledit matériau dopé ou ledit alliage;
- des moyens pour mesurer une différence de potentiel électrique entre le premier solide et le second solide, cette différence de potentiel étant représentative de la teneur en dopant ou de la teneur en élément allié à l'interface second liquide-second solide, c'est-à-dire à l'interface liquide dopé-solide dopé ou alliage liquide-alliage solide;
- des moyens pour mettre en court-circuit électrique ledit premier liquide et ledit second liquide ;
caractérisé en ce que lesdits moyens pour mettre en court-circuit électrique ledit premier liquide et ledit second liquide consistent en un passage de dimension réduite, isotherme et conducteur, reliant lesdites première et seconde cavité.

2. Dispositif selon la revendication 1 caractérisé en ce que, ledit passage se situe au voisinage de l'extrémité desdites cavités.

3. Dispositif selon la revendication 1 caractérisé en ce que ledit passage est formé d'un tube ou canal comportant une paroi ou pastille en un matériau conducteur de l'électricité.

4. Dispositif selon la revendication 1 caractérisé en ce que ledit passage est formé d'un tube ou canal obstrué par un matériau isolant électriquement, ledit matériau isolant étant traversé par un élément en un matériau conducteur de l'électricité.

5. Dispositif selon la revendication 1 caractérisé en ce que ledit passage est formé d'un tube ou canal dans lequel est placé un corps ou bouchon poreux en matériau électriquement isolant dont les pores ont été remplis du liquide du matériau non dopé ou du corps pur non allié.

6. Dispositif selon l'une quelconque des revendications 1 à 5 caractérisé en ce que ledit passage est perpendiculaire à l'axe principal desdites cavités.

7. Dispositif selon l'une quelconque des revendications 1 à 6 caractérisé en ce que ledit passage présente une section circulaire.

8. Dispositif selon l'une quelconque des revendications 1 à 7 caractérisé en ce que les deux cavités sont identiques.

9. Dispositif selon l'une quelconque des revendications 1 à 8 caractérisé en ce que les deux cavités sont réalisées dans un seul et même creuset.

10. Dispositif selon l'une quelconque des revendications 1 à 9 caractérisé en ce que lesdits premiers moyens comprennent, outre ladite première cavité, des premiers moyens de chauffage pour chauffer une première partie de ladite première cavité et y former ledit premier liquide dudit matériau non dopé ou dudit corps pur non allié et des premiers moyens de refroidissement pour refroidir une seconde partie de ladite première cavité et y former ledit premier solide ledit matériau non dopé ou dudit corps pur non allié, et en ce que lesdits seconds moyens comprennent outre ladite seconde cavité, des seconds moyens de chauffage pour chauffer une première partie de ladite seconde cavité et y former ledit second liquide dudit matériau dopé ou dudit alliage, et des seconds moyens de refroidissement pour refroidir une seconde partie de ladite seconde cavité et y former ledit second solide dudit matériau dopé ou dudit alliage.

11. Dispositif selon la revendication 10 caractérisé en ce que lesdits premiers moyens de refroidissement et lesdits seconds moyens de refroidissement consistent en un seul et même système de refroidissement.

12. Dispositif selon la revendication 10 ou 11 caractérisé en ce que lesdits premiers moyens de chauffage et lesdits seconds moyens de chauffage consistent en un seul et même four.

13. Dispositif selon les revendications 11 et 12 caractérisé en ce que ledit four et ledit système de refroidissement sont disposés l'un au dessus de l'autre et en ce que des moyens isolants thermiques sont prévus entre ledit four et ledit système de refroidissement.

14. Dispositif selon la revendication 1 caractérisé en ce que lesdits moyens pour mesurer une différence de potentiel entre le premier solide et le second solide comprennent des contacts électriques et en ce que lesdits contacts électriques et les extrémités des solides sont placés dans des moyens de régulation de la température et d'homogénéisation thermique.

15. Dispositif selon la revendication 14 caractérisé en ce que lesdits moyens de régulation de la température et d'homogénéisation thermique sont constitués par une masse de cuivre dans laquelle sont prévues des conduites où circule un fluide dont le débit et la température sont régulés par des moyens adéquats.

16. Dispositif selon l'une quelconque des revendications 1 à 15 caractérisé en ce que des moyens d'obturation et/ou des moyens de compensation de volume libre sont prévus à l'extrémité des cavités du côté - côté froid- où se trouvent les matériaux solides.

17. Dispositif selon l'une quelconque des revendications 1 à 16 caractérisé en ce que des moyens d'obturation et/ou de compensation de volume libre sont prévus à l'extrémité des cavités du côté -côté chaud- où se trouvent les matériaux liquides.

18. Dispositif selon la revendication 16 caractérisé en lesdits moyens d'obturation et/ou de compensation de volume libre comprennent un ressort qui gère l'expansion ou la rétraction moyenne en poussant sur une pièce contenant l'extrémité solide des échantillons.

19. Dispositif selon la revendication 18 caractérisé en ce que lesdits moyens d'obturation et/ou de compensation de volume libre comprennent en outre deux petits ressorts placés à l'intérieur de la pièce contenant l'extrémité solide des échantillons pour gérér les dilatations différentielles des échantillons en poussant sur les contacts électriques sous forme de pointes de mesure Seebeck.

20. Dispositif selon la revendication 17 caractérisé en ce que lesdits moyens d'obturation et/ou de compensation de volume libre comprennent deux ressorts qui poussent des pistons gérant l'expansion des échantillons liquides.

21. Dispositif selon la revendication 20 caractérisé en ce que lesdits pistons sont étanches au liquide mais poreux au gaz.

## Patentansprüche

1. Vorrichtung zur Erstarrung eines mit einem Dotierstoff dotierten Materials oder einer elektrisch leitfähigen Legierung und zur kontinuierlichen Überwachung der Kristallzüchtung bzw. des Kristallwachstums dieses Materials oder dieser Legierung, umfassend:
- erste Einrichtungen zur Bildung einer ersten Flüssigkeit aus dem nichtdotierten Material oder dem reinen nichtlegierten Körper im thermodynamischen Gleichgewicht mit einem ersten Festkörper aus dem genannten nichtdotierten Material oder dem genannten reinen nichtlegierten Körper, wobei die genannten ersten Einrichtungen einen ersten Hohlraum von im Wesentlichen länglicher Form umfassen, um das genannte nichtdotierte Material oder den genannten reinen Körper aufzunehmen;
- zweite Einrichtungen zum Bilden einer zweiten Flüssigkeit aus dem genannten dotierten Material oder der genannten Legierung im thermodynamischen Gleichgewicht mit einem zweiten Festkörper aus dem genannten dotierten Material oder der genannten Legierung, wobei die zweiten Einrichtungen einen zweiten Hohlraum von im Wesentlichen länglicher Form umfassen, um das genannte dotierte Material oder die genannte Legierung aufzunehmen;
- Einrichtungen zum Messen einer elektrischen Potentialdifferenz zwischen dem ersten Festkörper und dem zweiten Festkörper, wobei diese Potentialdifferenz repräsentativ ist für den Dotierstoffgehalt oder den Legierungselement-Gehalt an der Grenzfläche zweite Flüssigkeit-zweiter Festkörper, d.h. an der Grenzfläche dotierte Flüssigkeit-dotierter Festkörper oder flüssige Legierung-feste Legierung;
- Einrichtungen zum elektrischen Kurzschließen der genannten ersten Flüssigkeit mit der genannten zweiten Flüssigkeit;
**dadurch gekennzeichnet,**
dass die genannten Einrichtungen zum elektrischen Kurzschließen der genannten ersten Flüssigkeit und der genannten zweiten Flüssigkeit durch einen isothermischen und leitfähigen Verbindungsdurchgang von geringer Abmessung gebildet werden, der den ersten und den zweiten Hohlraum verbindet.

2. Vorrichtung nach Anspruch 1, dadurch gekennzeichnet, dass der genannte Verbindungsdurchgang sich in der Nähe des Endes der genannten Hohlräume befindet.

3. Vorrichtung nach Anspruch 1, dadurch gekennzeichnet, dass der genannte Verbindungsdurchgang durch ein Rohr oder einen Kanal mit einer Wand oder einem Plättchen aus einem elektrisch leitfähigen Material gebildet wird.

4. Vorrichtung nach Anspruch 1, dadurch gekennzeichnet, dass der genannte Verbindungsdurchgang durch ein elektrisch isolierendes Material verschlossen ist, wobei dieses isolierende Material von einem Element aus einem elektrisch leitfähigen Material durchquert wird.

5. Vorrichtung nach Anspruch 1, dadurch gekennzeichnet, dass der genannte Verbindungsdurchgang durch ein Rohr oder einen Kanal gebildet wird, in dem sich ein poröser Körper oder Stopfen aus elektrisch isolierendem Material befindet, dessen Poren mit der Flüssigkeit aus dem nichtdotierten Material oder dem reinen nichtlegierten Körper gefüllt worden sind.

6. Vorrichtung nach einem der Ansprüche 1 bis 5, dadurch gekennzeichnet, dass der genannte Verbindungsdurchgang senkrecht zur Hauptachse der genannten Hohlräume ist.

7. Vorrichtung nach einem der Ansprüche 1 bis 6, dadurch gekennzeichnet, dass der genannte Verbindungsdurchgang einen kreisrunden Querschnitt aufweist.

8. Vorrichtung nach einem der Ansprüche 1 bis 7, dadurch gekennzeichnet, dass die beiden Hohlräume genau gleich sind.

9. Vorrichtung nach einem der Ansprüche 1 bis 8, dadurch gekennzeichnet, dass die beiden Hohlräume in ein und demselben Tiegel realisiert sind.

10. Vorrichtung nach einem der Ansprüche 1 bis 9, dadurch gekennzeichnet, dass die genannten ersten Einrichtungen außer dem genannten ersten Hohlraum erste Heizeinrichtungen umfassen, um einen ersten Teil des genannten ersten Hohlraums zu heizen und dort die genannte erste Flüssigkeit aus dem genannten nichtdotierten Material oder dem genannten reinen nichtlegierten Körper zu bilden, und erste Kühleinrichtungen umfassen, um einen zweiten Teil des genannten ersten Hohlraums zu kühlen und dort den genannten ersten Festkörper aus dem genannten nichtdotierten Material oder dem genannten reinen nichtlegierten Körper zu bilden, und dadurch, dass die genannten zweiten Einrichtungen außer dem genannten zweiten Hohlraum zweite Heizeinrichtungen umfassen, um einen ersten Teil des genannten zweiten Hohlraums zu heizen und dort die genannte zweite Flüssigkeit aus dem genannten dotierten Material oder der genannten Legierung zu bilden, und zweite Kühleinrichtungen umfassen, um einen zweiten Teil des genannten zweiten Hohlraums zu kühlen und dort den genannten zweiten Festkörper aus dem genannten dotierten Material oder der genannten Legierung zu bilden.

11. Vorrichtung nach Anspruch 10, dadurch gekennzeichnet, dass die genannten ersten Kühleinrichtungen und die genannten zweiten Kühleinrichtungen durch ein und dasselbe Kühlsystem gebildet werden.

12. Vorrichtung nach Anspruch 10 oder 11, dadurch gekennzeichnet, dass die genannten ersten Heizeinrichtungen und die genannten zweiten Heizeinrichtungen durch ein und denselben Ofen gebildet werden.

13. Vorrichtung nach den Ansprüchen 11 und 12, dadurch gekennzeichnet, dass der genannte Ofen und das genannte Kühlsystem übereinander angeordnet sind, und dadurch, dass thermisch isolierende Einrichtungen zwischen dem genannten Ofen und dem genannten Kühlsystem vorgesehen sind.

14. Vorrichtung nach Anspruch 1, dadurch gekennzeichnet, dass die genannten Einrichtungen zum Messen einer Potentialdifferenz zwischen dem ersten Festkörper und dem zweiten Festkörper elektrische Kontakte umfassen und die Enden der Festkörper sich in Regulierungseinrichtungen der Temperatur und der thermischen Homogenisierung befinden.

15. Vorrichtung nach Anspruch 14, dadurch gekennzeichnet, dass die genannten Einrichtungen zur Regulierung der Temperatur und der thermischen Homogenisierung durch eine Kupfermasse gebildet werden, in der Leitungen vorgesehen sind, in denen ein Fluid fließt, dessen Durchsatzmenge und Temperatur durch adäquate Einrichtungen reguliert werden.

16. Vorrichtung nach einem der Ansprüche 1 bis 15, dadurch gekennzeichnet, dass am Ende der Hohlräume, auf der kalten Seite, wo sich die festen Materialien befinden, Einrichtungen zum Verschließen und/oder Einrichtungen zum Kompensieren von freiem Volumen vorgesehen sind.

17. Vorrichtung nach einem der Ansprüche 1 bis 16, dadurch gekennzeichnet, dass am Ende der Hohlräume, auf der warmen Seite, wo sich die flüssigen Materialien befinden, Einrichtungen zum Verschließen und/oder zum Kompensieren von freiem Volumen vorgesehen sind.

18. Vorrichtung nach Anspruch 16, dadurch gekennzeichnet, dass die genannten Einrichtungen zum Verschließen und/oder Kompensieren von freiem Volumen eine Feder umfassen, die die mittlere Expansion oder Retraktion leitet bzw. steuert, indem sie gegen ein Teil drückt, das das feste Ende der Proben enthält.

19. Vorrichtung nach Anspruch 18, dadurch gekennzeichnet, dass die genannten Einrichtungen zum Verschließen und/oder Kompensieren von freiem Volumen außerdem zwei kleine Federn umfassen, angeordnet im Innern des Teils, das das feste Ende der Proben enthält, um die Differentialdilatationen zu leiten bzw. zu steuern, indem sie auf die elektrischen Kontakte in Form von Seebeck-Messpunkten drücken.

20. Vorrichtung nach Anspruch 17, dadurch gekennzeichnet, dass die genannten Einrichtungen zum Verschließen und/oder Kompensieren von freiem Volumen zwei Federn umfassen, die auf Kolben drücken, die die Expansion der flüssigen Proben steuern.

21. Vorrichtung nach Anspruch 20, dadurch gekennzeichnet, dass die genannten Kolben dicht gegenüber Flüssigkeit aber durchlässig für Gas sind.

## Claims

1. Device for the solidification of a material doped by a dopant or of an alloy, the said material or alloy being electrically conducting, and for the continuous control of the crystal growth of this material or this alloy, comprising:
- first means for forming a first liquid of the undoped material or of the unalloyed pure substance in thermodynamic equilibrium with a first solid of the said undoped material or of the said unalloyed pure substance, the said first means comprising a first cavity of essentially elongated shape for housing the said undoped material or the said pure substance;
- second means for forming a second liquid of the said doped material or of the said alloy in thermodynamic equilibrium with a second solid of the said doped material or of the said alloy, the said second means comprising a second cavity of essentially elongate shape for housing the said doped material or the said alloy;
- means for measuring an electric potential difference between the first solid and the second solid, this potential difference being representative of the dopant content or of the alloyed-element content at the second liquid/second solid interface, that is to say at the doped liquid/doped solid or liquid alloy/solid alloy interface;
- means for electrically short-circuiting the said first liquid from the said second liquid;
characterized in that the said means for electrically short-circuiting the said first liquid from the said second liquid consist of a small-sized, isothermal and conducting passage connecting the said first and second cavities.

2. Device according to Claim 1 characterized in that the said passage lies near the end of the said cavities.

3. Device according to Claim 1 characterized in that the said passage is formed by a tube or channel having a wall or pad made of an electrically conducting material.

4. Device according to Claim 1, characterized in that the said passage is formed by a tube or channel obstructed by an electrically insulating material, an element made of an electrically conducting material passing through the said insulating material.

5. Device according to Claim 1, characterized in that the said passage is formed by a tube or channel in which is placed a porous body or plug made of an electrically insulating material, the pores of which have been filled with the liquid of the undoped material or of the unalloyed pure substance.

6. Device according to any one of Claims 1 to 5, characterized in that the said passage is perpendicular to the main axis of the said cavities.

7. Device according to any of Claims 1 to 6, characterized in that the said passage has a circular cross section.

8. Device according to any one of Claims 1 to 7, characterized in that the two cavities are identical.

9. Device according to any one of Claims 1 to 8, characterized in that the two cavities are made in one and the same crucible.

10. Device according to any one of Claims 1 to 9, characterized in that the said first means comprise, apart from the said first cavity, first heating means for heating a first part of the said first cavity and for forming therein the said first liquid of the said undoped material or of the said unalloyed pure substance and first cooling means for cooling a second part of the said first cavity and for forming therein the said first solid of the said undoped material or of the said unalloyed pure substance, and in that the said second means comprise, apart from the said second cavity, second heating means for heating a first part of the said second cavity and for forming therein the said second liquid of the said doped material or of the said alloy and second cooling means for cooling a second part of the said second cavity and for forming therein the said second solid of the said doped material or of the said alloy.

11. Device according to Claim 10, characterized in that the said first cooling means and the said second cooling means consist of one and the same cooling system.

12. Device according to Claim 10 or 11, characterized in that the said first heating means and the said second heating means consist of one and the same furnace.

13. Device according to Claims 11 and 12, characterized in that the said furnace and the said cooling system are placed one on top of the other and in that thermal insulation means are provided between the said furnace and the said cooling system.

14. Device according to Claim 1, characterized in that the said means for measuring a potential difference between the first solid and the second solid comprise electrical contacts and in that the said electrical contacts and the ends of the solids are placed in means for regulating the temperature and for creating thermal homogeneity.

15. Device according to Claim 14, characterized in that the said means for regulating the temperature and for creating thermal homogeneity consist of a copper mass in which pipes are provided, a fluid whose flow rate and temperature are regulated by suitable means flowing through the said pipes.

16. Device according to any one of Claims 1 to 15, characterized in that closure means and/or free-volume compensation means are provided at the end of the cavities on one side - the cold side - where the materials are solid.

17. Device according to any one of Claims 1 to 16, characterized in that closure means and/or free-volume compensation means are provided at the end of the cavities on one side - the hot side - where the materials are liquid.

18. Device according to Claim 16, characterized in that the said closure and/or free-volume compensation means comprise a spring which manages the mean expansion or retraction by pushing on a component containing the solid end of the samples.

19. Device according to Claim 18, characterized in that the said closure and/or free-volume compensation means furthermore comprise two small springs placed inside the component containing the solid end of the samples in order to manage the differential expansions of the samples by pushing on the electrical contacts in the form of Seebeck measurement points.

20. Device according to Claim 17, characterized in that the said closure and/or free-volume compensation means comprise two springs which push pistons managing the expansion of the liquid samples.

21. Device according to Claim 20, characterized in that the said pistons are impervious to liquids but permeable to gases.
